# EUROPÄISCHE PATENTSCHRIFT

(11) **EP 3 465 786 B1**
(45) Veröffentlichungstag und Bekanntmachung des Hinweises auf die Patenterteilung: **27.10.2021**
(21) Anmeldenummer: 17733347.3
(22) Anmeldetag: 31.05.2017
(51) Int. Cl.: H01L 41/25, H02N 2/00, C04B 37/00

(54) **VERFAHREN ZUM VERBINDEN EINES KERAMISCHEN FRIKTIONSELEMENTS MIT EINEM PIEZOKERAMISCHEN ELEMENT**
METHOD FOR JOINING A CERAMIC FRICTION ELEMENT TO A PIEZOCERAMIC ELEMENT
PROCÉDÉ DE LIAISON D'UN ÉLÉMENT DE FRICTION CÉRAMIQUE À UN ÉLÉMENT PIÉZOCÉRAMIQUE

(30) Priorität: 02.06.2016 DE 102016110209
(43) Veröffentlichungstag der Anmeldung: 10.04.2019
(73) Patentinhaber: Physik Instrumente (PI) GmbH & Co. KG, 76228 Karlsruhe (DE)
(72) Erfinder: WISCHNEWSKIY, Wladimir, 14712 Rathenow (DE); WISCHNEWSKI, Alexej, 76744 Wörth (DE)
(74) Vertreter: Kruspig, Volkmar
(86) Internationale Anmeldenummer: PCT/DE2017/100467
(87) Internationale Veröffentlichungsnummer: WO 2017/206995

(56) Entgegenhaltungen:
- DE-A1-102008 012 992
- JP-A- H06 196 770
- JP-A- H06 232 472

## Beschreibung

Die Erfindung betrifft ein Verfahren zum Verbinden eines keramischen Friktionselements mit einem piezokeramischen Element, vorzugsweise mit einem piezoelektrischen Aktor, gemäß Anspruch 1.

Aus der US 6 765 335 B2 ist ein piezoelektrischer Ultraschallmotor bekannt, dessen Ultraschallaktor aus einem Piezoelement besteht, das als Platte oder Zylinder aus piezokeramischem Material ausgeführt ist und an bzw. mit dem ein Friktionselement oder mehrere keramische Friktionselemente aus einem keramischen Material angeordnet bzw. verbunden ist/sind. Hierbei erfolgt die Verbindung des jeweiligen keramischen Friktionselements mit dem Piezoelement in der Regel auf zwei Arten.

In einer ersten Verbindungsart wird das Friktionselement mit Hilfe einer organischen Substanz, beispielsweise Epoxid-Klebstoff, an das Piezoelement geklebt. Der Nachteil dieser Klebemethode besteht darin, dass die maximale Temperatur, die der Kleber dauerhaft erträgt, durch seine Härtetemperatur bestimmt wird, welche zwischen 100 und 150°C beträgt. Diese Temperatur ist für viele industrielle Anwendungen nicht ausreichend. Außerdem besteht die Gefahr einer Kontamination durch den organischen Kleber beim Einsatz des Motors in einem Hochvakuum, weshalb so hergestellte Ultraschallmotoren nicht in Hochvakuumapplikationen einsetzbar sind.

Bei einer zweiten Verbindungsart erfolgt das Verbinden des Friktionselementes mit dem Piezoelement durch Kleben oder durch Aufschweißen mit einem Niedertemperaturglas. Das Friktionselement wird hierbei mit dem Piezoelement mittels hoher Temperatur verbunden und erst danach wird bei niedriger Temperatur die gesamte Piezokeramik polarisiert. Der Nachteil dieser Verbindungsmethode besteht darin, dass es bei der Polarisierung der Piezokeramik zu einer bedeutenden Verformung des Piezoelementes kommt, bedingt durch die Rotation der polaren Domänen der Piezokeramik. Dadurch entstehen im Bereich der Verbindung zwischen dem Friktionselement und dem Piezoelement beträchtliche mechanische Spannungen, welche die Festigkeit des Piezoelements negativ beeinflussen. Deshalb können so hergestellte Aktoren nicht in leistungsstarken Ultraschallmotoren eingesetzt werden.

DE 10 2008 012 992 A1 offenbart ein Verfahren zum Verbinden eines keramischen Friktionselementes mit einem Element aus piezokeramischem Material, welches ein Piezoelement definiert, wobei das Piezoelement wenigstens eine Erregerelektrode und wenigstens eine dazu beabstandete allgemeine Elektrode aufweist und zwischen der Erregerelektrode und der allgemeinen Elektrode zumindest ein Teil des piezokeramischen Materials des Piezoelements angeordnet ist, wobei das Verfahren folgende Verfahrensschritte umfasst: Zubereiten und Anordnen einer niedrigschmelzenden Glasmasse zwischen einer Verbindungsfläche des Friktionselementes und einer Kontaktfläche des Piezoelementes, Erhitzen des Piezoelementes und des Friktionselementes auf eine definierte Temperatur, sowie Abkühlen des Piezoelementes und des Friktionselementes bis auf Raumtemperatur.

JP H06 232472 A offenbart ein Verfahren zum Verbinden eines Halbleitersubstrats mit einem Piezoelement, mit folgenden Verfahrensschritten: Zubereiten einer niedrigschmelzenden Glasmasse, Anordnen der niedrigschmelzenden Glasmasse zwischen einer Verbindungsfläche des Substrats und einer Kontaktfläche des Piezoelementes, Erhitzen des Piezoelementes und des Substrats auf eine definierte Temperatur, die unter dem Curiepunkt des piezokeramischen Materials des Piezoelementes und über einen Schmelzpunkt der niedrigschmelzenden Glasmasse liegt, nach Erreichen der definierten Temperatur des Piezoelementes und des Substrats, Anlegen einer elektrischen Polarisationsspannung an Elektroden des Piezoelementes, so dass in dem piezokeramischen Material zwischen den Elektroden ein das piezokeramische Material polarisierendes elektrisches Feld entsteht, und Aufrechterhalten des elektrischen Feldes für einen definierten Zeitraum, Abkühlen des Piezoelementes und des Substrats unter Aufrechterhaltung des polarisierenden elektrischen Feldes, Entfernen der an die Elektroden angelegten Polarisationsspannung, und Abkühlen des 1b Piezoelementes und des Substrats bis auf Raumtemperatur ohne eine an die Elektroden angelegte elektrische Spannung.

JP H06 196770 A offenbart ein ähnliches Verfahren wie die vorgenannte Druckschrift, wobei jedoch das Anlegen einer elektrischen Polarisationsspannung nach der Abkühlung erfolgt.

Es ist Aufgabe der Erfindung, ein Verfahren zum Verbinden eines keramischen Friktionselements mit einem piezokeramischen Element bzw. Piezoelement bereitzustellen, bei welchem im Bereich der Verbindung nur geringe mechanische Spannungen entstehen, und bei welchem die so miteinander verbundenen Elemente bei höheren Temperaturen und in Hochvakuumapplikationen verwendbar sind.

Diese Aufgabe wird gelöst durch ein Verfahren gemäß Anspruch 1, wobei die sich daran anschließenden Unteransprüche wenigstens zweckmäßige Weiterbildungen darstellen.

Demgemäß wird von einem Verfahren zum Verbinden eines keramischen Friktionselementes mit einem Element aus piezokeramischem Material, welches ein Piezoelement definiert, ausgegangen, wobei das Piezoelement wenigstens eine Erregerelektrode und wenigstens eine dazu beabstandete allgemeine Elektrode aufweist und zwischen der Erregerelektrode und der allgemeinen Elektrode zumindest ein Teil des piezokeramischen Materials des Piezoelements angeordnet ist.

Das erfindungsgemäße Verfahren umfasst folgende Verfahrensschritte:
Schritt 1: Zubereiten einer niedrigschmelzenden Glasmasse;
Schritt 2: Anordnen der niedrigschmelzenden Glasmasse zwischen einer Verbindungsfläche des Friktionselementes und einer Kontaktfläche des Piezoelements bzw. Auftragen der niedrigschmelzenden Glasmasse auf einer Verbindungsfläche des Friktionselementes und/oder auf einer Kontaktfläche des Piezoelements;
Schritt 3: Aufbringen einer Presskraft und dadurch Gegeneinanderpressen der Verbindungsfläche des Friktionselements und der Kontaktfläche des Piezoelements mit der dazwischen angeordneten niedrigschmelzenden Glasmasse und Aufrechterhaltung der Presskraft für alle nachfolgenden Verfahrensschritte;
Schritt 4: Erhitzen des Piezoelements und des Friktionselements auf eine definierte Temperatur, die über dem Curiepunkt des piezokeramischen Materials des Piezoelements und über dem Schmelzpunkt der niedrigschmelzenden Glasmasse liegt;
Schritt 5: Nach Erreichen der definierten Temperatur des Piezoelements und des Friktionselements und unter Aufrechterhaltung der definierten Temperatur Anlegen einer elektrischen Polarisationsspannung Up an die Elektroden des Piezoelements, so dass in dem piezokeramischen Material zwischen den Elektroden ein das piezokeramische Material polarisierendes elektrisches Feld Ep entsteht, und Aufrechterhalten des elektrischen Feldes Ep für einen definierten Zeitraum;
Schritt 6: Abkühlen des Piezoelements und des Friktionselements unter Aufrechterhaltung des polarisierenden elektrischen Feldes Ep bis unterhalb des Curiepunktes, und nach Unterschreiten des Curiepunktes Entfernen der an die Elektroden angelegten elektrischen Polarisationsspannung Up;
Schritt 7: Abkühlen des Piezoelements und des Friktionselements bis auf Raumtemperatur ohne eine an die Elektroden angelegte elektrische Spannung.

Es kann von Vorteil sein, dass die niedrigschmelzende Glasmasse in Form eines Films oder einer Paste, bestehend aus einem organischen Bindemittel und niedrigschmelzenden Glaspartikeln, zubereitet wird. Hierbei kann es von Vorteil sein, dass die niedrigschmelzende Glasmasse auf der Kontaktfläche des Piezoelements und/oder der Verbindungsfläche des Friktionselements durch Aufschmelzen bei gleichzeitigem Verbrennen des organischen Bindemittels aufgebracht wird.

Ferner kann es von Vorteil sein, dass bei dem Zubereiten der niedrigschmelzenden Glasmasse Körner kalibrierter Größe einer feuerfesten Oxidkeramik darin eingebracht werden.

Weiterhin kann es von Vorteil sein, dass bei dem Anlegen der elektrischen Spannung an die Elektroden des Piezoelements eine Stabilisierung eines Polarisationsstromes erfolgt.

Außerdem kann es von Vorteil sein, dass wenigstens die Verfahrensschritte 4 bis 6 derart ausgeführt werden, dass sich das Piezoelement und das Friktionselement in einem Ofen befinden.

Hierbei kann es von Vorteil sein, wenn die Verfahrensschritte 4 bis 6 unter einer Inertgas-Atmosphäre durchgeführt werden.

Es zeigen:
Fig. 1: Piezoelement in Form eines rechteckigen piezoelektrischen Aktors mit einem daran anzubringenden Friktionselement
Fig. 2: Schematischer Aufbau zur Durchführung des erfindungsgemäßen Verfahrens

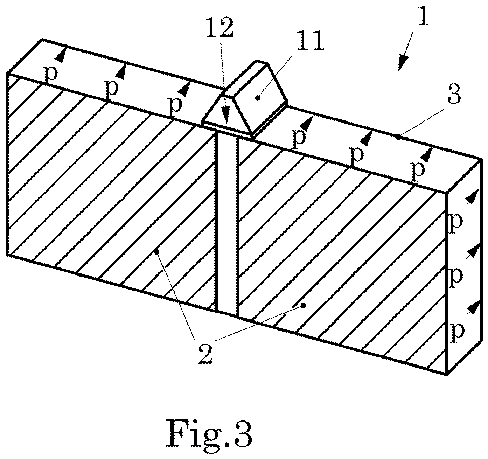

Fig. 3: Piezoelement gemäß Fig. 1 mit einem nach dem erfindungsgemäßen Verfahren damit verbundenen Friktionselement

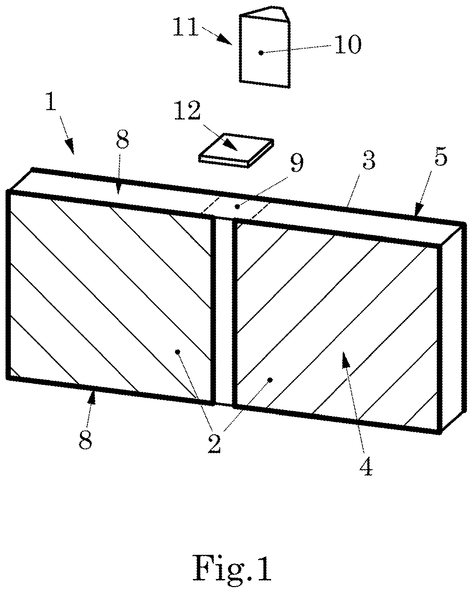

Figur 1 zeigt ein Piezoelement 1 in Form einer rechteckigen Platte aus einem piezokeramischen Material, nämlich harter piezoelektrischer PZTbasierter Keramik des Systems PbTiO₃―PbZrO₃ mit verschiedenen Zusätzen. An der in Fig. 1 nach vorne weisenden Hauptfläche 4 des Piezoelements 1 sind Erregerelektroden 2 angeordnet, und an der in Fig. 1 nach hinten weisenden, nicht zu ersehenden Hauptfläche 5 ist eine gemeinsame Elektrode 3 angeordnet. Das Piezoelement 1 umfasst insgesamt vier Seitenflächen 8, wobei die in Fig. 1 nach oben weisende Seitenfläche 8 einen Bereich aufweist, der eine Kontaktfläche 9 definiert, und die Kontaktfläche 9 zum Verbinden mit der Verbindungsfläche 10 des Friktionselements 11 über eine niedrigschmelzenden Glasmasse 12 vorgesehen ist.

Die Temperatur des Curiepunktes für die Piezokeramik des Piezoelements liegt im Bereich zwischen 280 und 350°C. Das Friktionselement 11 besteht aus einer Oxidkeramik auf der Basis von Al₂O₃ . Es kann ebenso aus ZrO₂, SiC, Si₃N₄ oder aus anderer harten abriebfesten Oxidkeramik bestehen. Überdies kann das Friktionselement auch aus harten Monokristallen wie zum Beispiel aus Saphir, Rubin oder Korund gefertigt sein.

Die niedrigschmelzende Glasmasse 12 besteht aus niedrigschmelzenden Glaspartikeln und einem Bindematerial. Als niedrigschmelzendes und Blei enthaltendes Glas kommt ein System aus PbO-P₂O₅ zum Einsatz. Denkbar sind zudem Systeme aus Pb(PO₃)₂ - Zn(BO₂)₂, Pb(PO₃)₂ - V₂O₅ oder PbO - B₂O₃ mit verschiedenen Additiven. Ferner können auch andere Systeme mit niedrigschmelzendem Glas verwendet werden, die eine stabile Verbindung mit der piezoelektrischen PZT-basierten Keramik des Piezoelementes 1 und der Oxidkeramik des Friktionselementes 11 eingehen. Die Größe der Glaspartikel kann im Bereich von 10 bis 100µm liegen und beträgt hier 50µm.

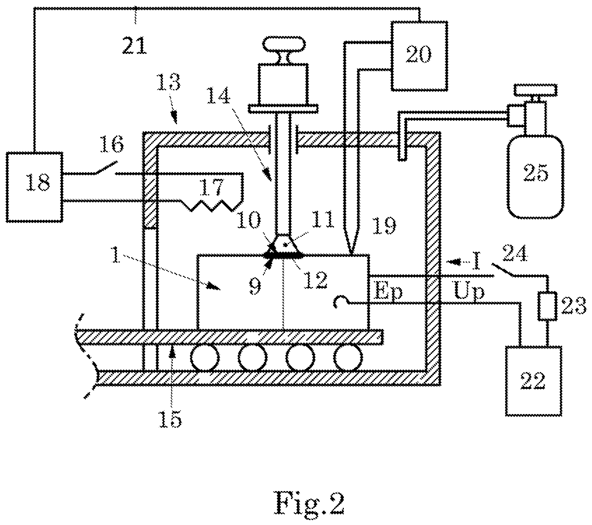

Figur 2 zeigt in schematischer Weise den instrumentellen Aufbau zur Durchführung des erfindungsgemäßen Verfahrens. Das Piezoelement ist hierbei zusammen mit dem Friktionselement in einem Ofen 13 platziert. Vordem Einsetzen in den Ofen erfolgen die Verfahrensschritte 1 und 2, nämlich das Zubereiten der niedrigschmelzenden Glasmasse und das Anordnen der niedrigschmelzenden Glasmasse zwischen der Verbindungsfläche 10 des Friktionselementes 11 und der Kontaktfläche 9 des Piezoelements 1.

In Verfahrensschritt 1 werden die Körner des niedrigschmelzenden Glases mit einem Bindemittel gemischt. Der niedrigschmelzenden Glasmasse werden Körner kalibrierter Größe einer feuerfesten Oxidkeramik, wie zum Beispiel Al₂O₃ oder ZrO₂ beigefügt. Die Teilchengröße bestimmt die Schichtdicke der niedrigschmelzenden Glasmasse und kann im Bereich zwischen 10 und 100µm liegen. Als Bindematerial können unterschiedliche organische Materialien verwendet werden, wie zum Beispiel Vaseline, Paraffin, Polyvinylalkohol und andere Materialien, die bei der in einem nachfolgenden Verfahrensschritt applizierten Wärme verbrennen oder verdampfen. Anschließend wird die niedrigschmelzende Glasmasse zu einer dünnen Folie mit einer Dicke zwischen 0,05 und 0,2µm oder zu einer Paste verarbeitet.

In Verfahrensschritt 2 wird die niedrigschmelzende Glasmasse in Form einer Folie zwischen dem Friktionselement 11 und dem Piezoelement 1 platziert, bzw. die niedrigschmelzende Glasmasse in Form einer Paste wird auf die Verbindungsfläche 10 des Friktionselements 11 und/oder auf die Kontaktfläche 9 des Piezoelements 1 aufgebracht. Es ist weiterhin denkbar, die niedrigschmelzende Glasmasse auf die Verbindungsfläche 10 des Friktionselementes 11 und/oder auf die Kontaktfläche 9 des Piezoelementes 1 aufzuschmelzen.

Anschließend erfolgt mit Verfahrensschritt 3 das Aufbringen einer Presskraft und dadurch ein Gegeneinanderpressen der Verbindungsfläche 10 des Friktionselements 11 und der Kontaktfläche 9 des Piezoelements 1 mit der dazwischen angeordneten niedrigschmelzenden Glasmasse 12 und Aufrechterhaltung der Presskraft für alle nachfolgenden Verfahrensschritte. Im konkreten Beispiel werden die gemäß den Verfahrensschritten 1 und 2 vorbereiteten Teile Piezoelement 1 und Friktionselement 11 vordem Gegeneinanderpressen mittels einer Linearführungsvorrichtung 15 in den Innenraum des Ofens 13 verbracht, wo die Applikation einer Kraft zum Gegeneinanderpressen der Verbindungsfläche 10 des Friktionselements 11 und der Kontaktfläche 9 des Piezoelements 1 durch einen von außen in den Ofenraum ragenden Stempel 14 realisiert ist, der das Friktionselement 11 in Richtung des Piezoelements 1 drückt, und welcher außerhalb des Ofens mit einem Gewicht belastet ist. Die so auf das Friktionselement 11 ausgeübte Druck- oder Presskraft, mit welcher die Verbindungsfläche 10 des Friktionselements 11 gegen die Kontaktfläche 9 des Piezoelements 1 gedrückt wird unter gleichzeitigem Vorhandensein der niedrigschmelzenden Glasmasse 12 zwischen ihnen, wird für alle nachfolgenden Verfahrensschritte aufrechterhalten.

Bei Verfahrensschritt 4 erfolgt das Erhitzen des Piezoelements 1 und des Friktionselements 11 in dem Ofen 13 mittels der Heizung 17 durch Schließen des Schalters 16 auf eine definierte Temperatur, die über dem Curiepunkt des piezokeramischen Materials des Piezoelements 1 und über einem Schmelzpunkt der niedrigschmelzenden Glasmasse 12 liegt. Diese definierte Temperatur liegt zwischen 400 und 500°C.

Die Heiztemperatur wird mit Hilfe eines Temperaturfühlers 19 und eines Steuergeräts 20 überwacht. Das Steuergerät 20 für den Temperaturfühler 19 kann über die elektrische Verbindung 21 mit der Vorrichtung 18 zur automatischen Temperaturregelung der Heizung 17 verbunden werden.

Gleichzeitig mit Durchführung des Verfahrensschritts 4 wird mit Verfahrensschritt 5 an die Elektroden 2 und 3 des Piezoelementes 1 die von einer elektrischen Spannungsversorgung 22 bereitgestellte elektrische Polarisationsspannung Up über den Widerstand 23 und den Schalter 24 angelegt. Die Spannungshöhe ist dabei so gewählt, dass ein Polarisationsfeld Ep entsteht, dessen Feldstärke zwischen 500 und 1000V/mm liegt. Die Feldstärke des Polarisationsfeldes Ep ist dabei vom Typ der zu polarisierenden Piezokeramik abhängig. Beim Erreichen der Schmelztemperatur der niedrigschmelzenden Glasmasse beginnt ein entsprechender Schmelzprozess, und es setzt eine Diffusion der Glasmoleküle über die Kontaktfläche 9 in den zur Kontaktfläche angrenzenden Bereich des Piezoelements 1 und über die Verbindungsfläche 10 in den zur Verbindungsfläche 10 angrenzenden Bereich des Friktionselementes 11 ein. Gleichzeitig werden die organischen Bindemittelbestandteile der niedrigschmelzenden Glasmasse vollständig verbrannt oder verdampft, so dass nur das niedrigschmelzende Glasmaterial übrigbleibt.

Die hohe Aufheiztemperatur, welcher auch das Piezoelement unterliegt, hat den positiven Nebeneffekt, dass die Domänen der Piezokeramik stark in Schwingungen versetzt werden, wodurch sich diese schon durch ein vergleichsweise niedriges elektrisches Feld Ep einfach in eine Richtung ausrichten lassen. Mit anderen Worten gelingt unter dem Temperatureinfluss ein leichteres bzw. schnelleres Polarisieren der Piezokeramik.

Bei der Ausrichtung der Domänen in der Piezokeramik wird die Piezokeramik leicht verformt. Da sich die niedrigschmelzende Glasmasse bei diesem Vorgang jedoch in geschmolzenen Zustand befindet, führt dies nicht zu mechanischen Spannungen auf der Oberfläche bzw. innerhalb des Piezoelementes 1 und des Friktionselementes 11.

Nach einer Polarisationshaltezeit zwischen 5 und 20 Minuten wird in Verfahrensschritt 6 die Heiztemperatur auf eine Temperatur unterhalb des Curiepunkts der piezoelektrischen Keramik des Piezoelements 1 abgesenkt. Dabei werden die Domänen der Piezokeramik in der nun im Wesentlichen unidirektionalen Lage fixiert und der Polarisationsprozess beendet. Jetzt kann das Polarisationsfeld Ep bzw. die Polarisationsspannung Up entfernt und die Temperatur entweder innerhalb oder außerhalb des Ofens 13 auf Raumtemperatur ohne das Anliegen einer elektrischen Spannung an den Elektroden des Piezoelements abgesenkt werden. Dabei erstarrt das niedrigschmelzende Glas vollständig.

Während der Phasen des Aufheizens und des Abkühlens des Piezoelementes 1 innerhalb der entsprechenden Verfahrensschritte kann der Polarisationsstrom Ip stabilisiert werden. Dies kann mit Hilfe eines Begrenzungswiderstands 23 erreicht werden.

Sofern die Elektroden 2, 3 des Piezoelementes 1 aus Silber (Ag) bestehen, kann der zuvor beschriebene Verbindungsprozess unter einer Luft-Atmosphäre durchgeführt werden. Bestehen die Elektroden 2, 3 des Piezoelementes 1 jedoch aus dem System Chrom (Cr) - Kupfer (Cu) - Nickel (Ni)(Gold (Au)) oder wurden diese durch chemisches Abscheiden von Nickel (Ni) hergestellt, ist es vorteilhaft, wenn die Verfahrensschritte 4 bis 6 unter einer Inertgas-Atmosphäre, z.B. unter einer Argon-Atmosphäre, durchgeführt werden, wobei das entsprechende Inertgas aus einem Druckbehälter 25 in den Innenraum des Ofens 13 geleitet werden kann. Dies verringert bzw. unterbindet eine Oxidation der Elektroden bei der hohen Aufheiztemperatur des Piezoelementes 1.

## Patentansprüche

1. Verfahren zum Verbinden eines keramischen Friktionselementes (11) mit einem Element aus piezokeramischem Material, welches ein Piezoelement (1) definiert, wobei das Piezoelement (1) wenigstens eine Erregerelektrode (2) und wenigstens eine dazu beabstandete allgemeine Elektrode (3) aufweist und zwischen der Erregerelektrode (2) und der allgemeinen Elektrode (3) zumindest ein Teil des piezokeramischen Materials des Piezoelements (1) angeordnet ist, wobei das Verfahren folgende Verfahrensschritte umfasst:
- Schritt 1: Zubereiten einer niedrigschmelzenden Glasmasse (12);
- Schritt 2: Anordnen der niedrigschmelzenden Glasmasse (12) zwischen einer Verbindungsfläche (10) des Friktionselementes (11) und einer Kontaktfläche (9) des Piezoelements (1);
- Schritt 3: Aufbringen einer Presskraft und Gegeneinanderpressen der Verbindungsfläche (10) des Friktionselements (11) und der Kontaktfläche (9) des Piezoelements (1) mit der dazwischen angeordneten niedrigschmelzenden Glasmasse (12) und Aufrechterhaltung der Presskraft für alle nachfolgenden Verfahrensschritte;
- Schritt 4: Erhitzen des Piezoelements (1) und des Friktionselements (11) auf eine definierte Temperatur, die über dem Curiepunkt des piezokeramischen Materials des Piezoelements (1) und über dem Schmelzpunkt der niedrigschmelzenden Glasmasse (12) liegt;
- Schritt 5: Nach Erreichen der definierten Temperatur des Piezoelements (1) und des Friktionselements (11) und unter Aufrechterhaltung der definierten Temperatur Anlegen einer elektrischen Polarisationsspannung Up an die Elektroden (2, 3) des Piezoelements (1), so dass in dem piezokeramischen Material zwischen den Elektroden (2, 3) ein das piezokeramische Material polarisierendes elektrisches Feld Ep entsteht, und Aufrechterhalten des elektrischen Feldes Ep für einen definierten Zeitraum;
- Schritt 6: Abkühlen des Piezoelements (1) und des Friktionselements (11) unter Aufrechterhaltung des polarisierenden elektrischen Feldes Ep bis unterhalb des Curiepunktes, und nach Unterschreiten des Curiepunktes Entfernen der an die Elektroden (2, 3) angelegten elektrischen Polarisationsspannung Up;
- Schritt 7: Abkühlen des Piezoelements (1) und des Friktionselements (11) bis auf Raumtemperatur ohne eine an die Elektroden (2, 3) angelegte elektrische Spannung.

2. Verfahren nach Anspruch 1, **dadurch gekennzeichnet, dass** die niedrigschmelzende Glasmasse (12) in Form eines Films oder einer Paste, bestehend aus einem organischen Bindemittel und niedrigschmelzenden Glaspartikeln, zubereitet wird.

3. Verfahren nach Anspruch 2, **dadurch gekennzeichnet, dass** die niedrigschmelzende Glasmasse (12) auf der Kontaktfläche (9) des Piezoelements (1) und/oder der Verbindungsfläche (10) des Friktionselements (11) durch Aufschmelzen bei gleichzeitigem Verbrennen des organischen Bindemittels aufgebracht wird.

4. Verfahren nach einem der vorhergehenden Ansprüche, **dadurch gekennzeichnet, dass** bei dem Zubereiten der niedrigschmelzenden Glasmasse (12) Körner kalibrierter Größe einer feuerfesten Oxidkeramik darin eingebracht werden.

5. Verfahren nach einem der vorhergehenden Ansprüche, **dadurch gekennzeichnet, dass** bei dem Anlegen der elektrischen Polarisationsspannung Up an die Elektroden (2, 3) des Piezoelements (1) eine Stabilisierung eines Polarisationsstromes Ip erfolgt.

6. Verfahren nach einem der vorhergehenden Ansprüche, **dadurch gekennzeichnet, dass** wenigstens die Verfahrensschritte 4 bis 6 derart ausgeführt werden, dass sich das Piezoelement (1) und das Friktionselement (11) in einem Ofen (13) befinden.

7. Verfahren nach Anspruch 6, **dadurch gekennzeichnet, dass** die Verfahrensschritte unter einer Inertgas-Atmosphäre durchgeführt werden.

## Claims

1. A method for joining a ceramic friction element (11) to an element of piezoceramic material, which defines a piezo element (1), wherein the piezo element (1) includes at least one exciter electrode (2) and at least one general electrode (3) spaced thereto, and at least a part of the piezoceramic material of the piezo element (1) is arranged between the exciter electrode (2) and the general electrode (3), wherein the method comprises the following method steps:
- step 1: preparing a low-melting glass mass (12);
- step 2: arranging the low-melting glass mass (12) between a connecting surface (10) of the friction element (11) and a contact surface (9) of the piezo element (1);
- step 3: applying a compressive force and pressing the connecting surface (10) of the friction element (11) and the contact surface (9) of the piezo element (1) against each other with the low-melting glass mass (12) arranged in between, and maintaining the compressive force for all of the subsequent method steps;
- step 4: heating the piezo element (1) and the friction element (11) to a defined temperature, which is above the Curie point of the piezoceramic material of the piezo element (1) and above the melting point of the low-melting glass mass (12);
- step 5: after having reached the defined temperature of the piezo element (1) and the friction element (11) and while maintaining the defined temperature, applying an electric polarization voltage Up to the electrodes (2, 3) of the piezo element (1) so that within the piezoceramic material between the electrodes (2, 3) an electric field Ep polarizing the piezoceramic material is generated, and maintaining the electric field Ep for a defined period of time;
- step 6: cooling the piezo element (1) and the friction element (11) while maintaining the polarizing electric field Ep to below the Curie point, and after having fallen below the Curie point, removing the electric polarization voltage Up applied to the electrodes (2, 3);
- step 7: cooling the piezo element (1) and the friction element (11) to room temperature without applying an electric voltage to the electrodes (2, 3).

2. The method according to claim 1, **characterized in that** the low-melting glass mass (12) is prepared in the form of a film or a paste consisting of an organic binder and low-melting glass particles.

3. The method according to claim 2, **characterized in that** the low-melting glass mass (12) on the contact surface (9) of the piezo element (1) and/or the connecting surface (10) of the friction element (11) is applied by fusing while simultaneously burning the organic binder.

4. The method according to any one of the preceding claims, **characterized in that**, when the low-melting glass mass (12) is prepared, grains of a calibrated size of refractory oxide ceramics are introduced in it.

5. The method according to any one of the preceding claims, **characterized in that**, when the electric polarization voltage Up is applied to the electrodes (2, 3) of the piezo element (1), stabilization of a polarization current Ip is performed.

6. The method according to any one of the preceding claims, **characterized in that** the method steps 4 to 6 are executed such that the piezo element (1) and the friction element (11) are located in a furnace (13).

7. The method according to claim 6, **characterized in that** the method steps are executed in an inert gas atmosphere.

## Revendications

1. Procédé de liaison d'un élément de friction en céramique (11) à un élément en matériau piézocéramique définissant un élément piézoélectrique (1), l'élément piézoélectrique (1) présentant au moins une électrode d'excitation (2) et au moins une électrode générale (3) espacée de celle-ci, et au moins une partie du matériau piézocéramique de l'élément piézoélectrique (1) étant interposée entre l'électrode d'excitation (2) et l'électrode générale (3), le procédé comprenant les étapes suivantes consistant à :
- étape 1 : préparer une masse de verre à bas point de fusion (12) ;
- étape 2 : disposer la masse de verre à bas point de fusion (12) entre une surface de liaison (10) de l'élément de friction (11) et une surface de contact (9) de l'élément piézoélectrique (1) ;
- étape 3 : appliquer une force de pression, et presser la surface de liaison (10) de l'élément de friction (11) et la surface de contact (9) de l'élément piézoélectrique (1) l'une contre l'autre, avec la masse de verre à bas point de fusion (12) interposée, et maintenir la force de pression pour toutes les étapes ultérieures du procédé ;
- étape 4 : chauffer l'élément piézoélectrique (1) et de l'élément de friction (11) à une température définie qui est supérieure au point de Curie du matériau piézocéramique de l'élément piézoélectrique (1) et supérieure au point de fusion de la masse de verre à bas point de fusion (12) ;
- étape 5 : après avoir atteint la température définie de l'élément piézoélectrique (1) et de l'élément de friction (11) et tout en maintenant la température définie, appliquer une tension de polarisation électrique Up aux électrodes (2, 3) de l'élément piézoélectrique (1) de sorte qu'un champ électrique Ep polarisant le matériau piézocéramique soit généré dans le matériau piézocéramique entre les électrodes (2, 3), et maintenir le champ électrique Ep pendant une période de temps définie ;
- étape 6 : refroidir l'élément piézoélectrique (1) et l'élément de friction (11) tout en maintenant le champ électrique de polarisation Ep en dessous du point de Curie, et après être passé en dessous du point de Curie, supprimer la tension électrique de polarisation Up appliquée aux électrodes (2, 3) ; et
étape 7 : refroidir l'élément piézoélectrique (1) et de l'élément de friction (11) à la température ambiante sans application d'une tension électrique aux électrodes (2, 3).

2. Procédé selon la revendication 1, **caractérisé en ce que** la masse de verre à bas point de fusion (12) est préparée sous la forme d'un film ou d'une pâte constitué(e) d'un liant organique et de particules de verre à bas point de fusion.

3. Procédé selon la revendication 2, **caractérisé en ce que** la masse de verre à bas point de fusion (12) est appliquée sur la surface de contact (9) de l'élément piézoélectrique (1) et/ou sur la surface de liaison (10) de l'élément de friction (11) par fusion tout en brûlant simultanément le liant organique.

4. Procédé selon l'une des revendications précédentes, **caractérisé en ce que**, lors de la préparation de la masse de verre à bas point de fusion (12), des grains de taille calibrée d'une céramique d'oxyde réfractaire sont introduits dans ladite masse.

5. Procédé selon l'une des revendications précédentes, **caractérisé en ce que**, pendant l'application de la tension de polarisation électrique Up aux électrodes (2, 3) de l'élément piézoélectrique (1), il se produit une stabilisation d'un courant de polarisation Ip.

6. Procédé selon l'une des revendications précédentes, **caractérisé en ce qu'**au moins les étapes 4 à 6 du procédé sont réalisées de telle sorte que l'élément piézoélectrique (1) et l'élément de friction (11) se trouvent dans un four (13).

7. Procédé selon la revendication 6, **caractérisé en ce que** les étapes du procédé sont réalisées sous une atmosphère de gaz inerte.
